# EUROPEAN PATENT APPLICATION

(11) **EP 4 703 450 A1**
(43) Date of publication of application: **04.03.2026**
(21) Application number: 25197118.0
(22) Date of filing: 20.08.2025
(51) Int. Cl.: C09K 5/14

(54) **ONE-PART DISPENSABLES HAVING HIGH STABLE FLOW RATES**

(30) Priority: 29.08.2024 CN 202411203404
(71) Applicant: Tianjin Laird Technologies Limited, Tianjin 300457 (CN)
(72) Inventor: FU, Hongguang, Tianjin, 300457 (CN); LU, Xuefeng, Tianjin, 300457 (CN)
(74) Representative: Lind Edlund Kenamets Intellectual Property AB

(57) **Abstract**

Disclosed are exemplary composites useful for the management of heat and/or electromagnetic interference (EMI), such as one-part dispensable thermal management and/or electromagnetic interference (EMI) mitigation materials, *etc.* In exemplary embodiments, a composite comprises a matrix, one or more fillers within the matrix, and a temperature-activatable thixotropic agent within the matrix. The temperature-activatable thixotropic agent is activatable upon heating of the composite to a predetermined minimum temperature for at least a predetermined minimum amount of time whereby activation of the temperature-activatable thixotropic agent increases flow rate and flow rate stability over time of the composite. Also disclosed are exemplary methods of enhancing flow rate characteristics of composites that are useful for management of heat and/or electromagnetic interference (EMI). In exemplary methods, a temperature-activatable thixotropic agent is used to increase flow rate and increase flow rate stability over time of the composite.

## Description

### FIELD

The present disclosure relates to one-part dispensables (broadly, composites) configured to have high stable flow rates over time. The one-part dispensables may comprise single part dispensable thermal management and/or electromagnetic interference (EMI) mitigation materials, such as single part dispensable thermal interface materials (TIMs) (*e.g.,* high thermally-conductive single part dispensable gap filler, *etc*.)*,* single part dispensable EMI absorber materials, single part dispensable thermally-conductive EMI absorber materials, single part dispensable electrically-conductive materials, *etc.*

### BACKGROUND

This section provides background information related to the present disclosure which is not necessarily prior art.

Electrical components, such as semiconductors, integrated circuit packages, transistors, *etc.,* typically have pre-designed temperatures at which the electrical components optimally operate. Ideally, the pre-designed temperatures approximate the temperature of the surrounding air. But the operation of electrical components generates heat. If the heat is not removed, the electrical components may then operate at temperatures significantly higher than their normal or desirable operating temperature. Such excessive temperatures may adversely affect the operating characteristics of the electrical components and the operation of the associated device.

To avoid or at least reduce the adverse operating characteristics from the heat generation, the heat should be removed, for example, by conducting the heat from the operating electrical component to a heat sink. The heat sink may then be cooled by conventional convection and/or radiation techniques. During conduction, the heat may pass from the operating electrical component to the heat sink either by direct surface contact between the electrical component and heat sink and/or by contact of the electrical component and heat sink surfaces through an intermediate medium or thermal interface material (TIM). The thermal interface material may be used to fill the gap between thermal transfer surfaces, in order to increase thermal transfer efficiency as compared to having the gap filled with air, which is a relatively poor thermal conductor.

In addition, a common problem in the operation of electronic devices is the generation of electromagnetic radiation within the electronic circuitry of the equipment. Such radiation may result in electromagnetic interference (EMI) or radio frequency interference (RFI), which can interfere with the operation of other electronic devices within a certain proximity. Without adequate shielding, EMI/RFI interference may cause degradation or complete loss of important signals, thereby rendering the electronic equipment inefficient or inoperable.

A common solution to ameliorate the effects of EMI/RFI is through the use of shields capable of absorbing and/or reflecting and/or redirecting EMI energy. These shields are typically employed to localize EMI/RFI within its source, and to insulate other devices proximal to the EMI/RFI source. These shields may be composed of metal, polymer-inorganic composites, filled foams, foam materials wrapped or coated with absorbing and/or reflecting materials, and the like.

The term "EMI" as used herein should be considered to generally include and refer to EMI emissions and RFI emissions, and the term "electromagnetic" should be considered to generally include and refer to electromagnetic and radio frequency from external sources and internal sources. Accordingly, the term shielding (as used herein) broadly includes and refers to mitigating (or limiting) EMI and/or RFI, such as by absorbing, reflecting, blocking, and/or redirecting the energy or some combination thereof so that it no longer interferes, for example, for government compliance and/or for internal functionality of the electronic component system.

### DRAWINGS

The drawings described herein are for illustrative purposes only of selected embodiments and not all possible implementations, and is not intended to limit the scope of the present disclosure.

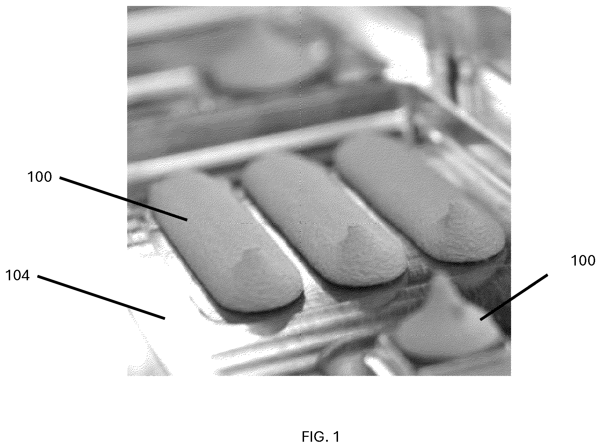

FIG. 1 shows one-part dispensables that may be configured to have high stable flow rates over time according to exemplary embodiments of the present disclosure.

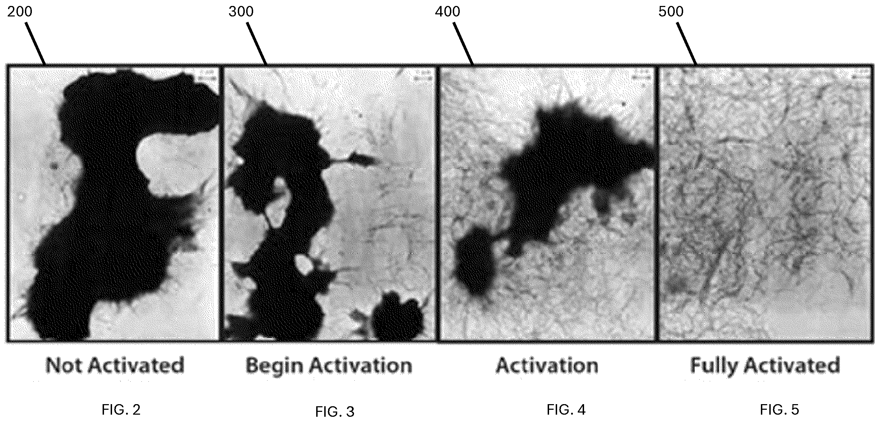

FIGS. 2, 3, 4, and 5 include microscopic images showing an exemplary embodiment of a one-part dispensable including a temperature-activatable thixotropic agent at different stages of activation (*e.g*., while the one-part dispensable is being heated up to a temperature of 80 °C to 100°C for at least 15 minutes, *etc.*)*.*

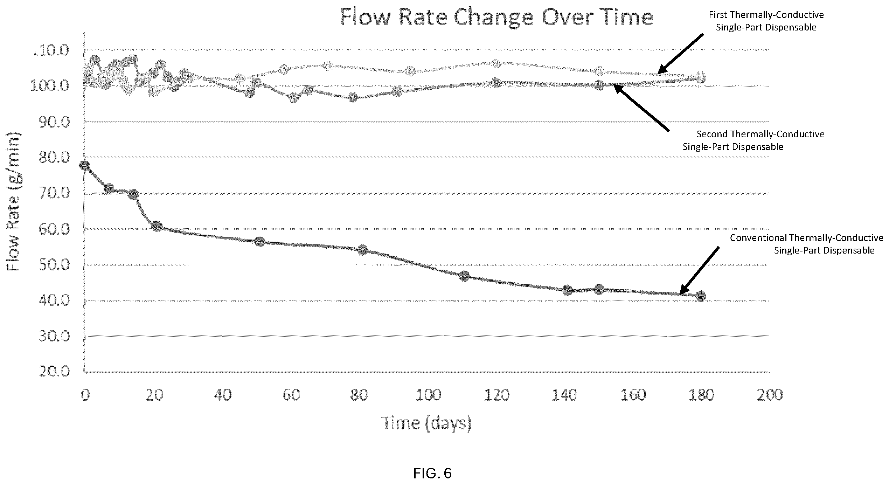

FIG. 6 is a line graph of flow rate in grams per minute (g/min) versus time in days for first and second thermally-conductive single-part dispensables according to exemplary embodiments of the present disclosure. For comparison purposes, FIG. 6 also includes results for a conventional thermally conductive single-part dispensable that did not include a temperature-activatable thixotropic agent.

### DETAILED DESCRIPTION

Example embodiments will now be described more fully with reference to the accompanying drawings.

As recognized herein, one-part dispensable thermal interface materials (TIMs) are commonly used due to the advantages they provide. For example, no mixing is needed for one-part dispensable TIMs. And a simpler valve design may be used for one-part dispensable TIMs without a disposable static mixer. One-part dispensable TIM may be used as is and no curing or post processing is needed, thereby eliminating the possibility of accidently curing in line. Only one dispensing pump is needed for dispensing one-part dispensable TIMs, and no ratio control is necessary. It is also possible to rework and/or reuse one-part dispensable TIMs, which may be easier to remove from application clean up. But as further recognized herein, one-part dispensable TIMs suffer from instable flow rates that drop over time.

After recognizing the above, exemplary embodiments were developed and/or are disclosed herein of composites useful for the management of heat and/or electromagnetic interference (EMI), such as one-part dispensable thermal management and/or electromagnetic interference (EMI) mitigation materials, *etc.* In exemplary embodiments, a composite comprises a matrix, one or more fillers within the matrix, and a temperature-activatable thixotropic agent within the matrix. The temperature-activatable thixotropic agent is activatable upon heating of the composite to a predetermined minimum temperature for at least a predetermined minimum amount of time whereby activation of the temperature-activatable thixotropic agent increases flow rate and flow rate stability over time of the composite. Also disclosed are exemplary methods of enhancing flow rate characteristics of composites that are useful for management of heat and/or electromagnetic interference (EMI). In exemplary methods, a temperature-activatable thixotropic agent is used to increase flow rate and increase flow rate stability over time of the composite.

With reference to the figures, FIG. 1 shows a one-part dispensable 100 (broadly, a composite) configured to have a high stable flow rate over time according to an exemplary embodiment of the present disclosure. As shown, the a plurality of the one-part dispensables 100 have been dispensed on a substrate 104.

The one-part dispensable 100 comprises a matrix, one or more fillers within the matrix, and temperature-activatable thixotropic agent within the matrix. The temperature-activatable thixotropic agent is activatable upon heating of the composite to a predetermined minimum temperature (*e.g*., at least about 80°C to 100°C, *etc.*) for at least a predetermined minimum amount of time (*e.g.,* about 15 minutes, *etc.*)*.* Activation of the temperature-activatable thixotropic agent increases flow rate and flow rate stability over time of the composite. For example, the one-part dispensable 100 may have a stable flow rate of at least about 100 grams per minute and/or a stable flow rate within a range from 90 grams per minute to 125 grams per minute for at least 180 days.

In this exemplary embodiment, the one-part dispensable 100 includes about 0.1 weight percent to about 0.5 weight percent of the temperature-activatable thixotropic agent based on a total weight of the composite. For example, the one-part dispensable 100 may include about 0.1 weight percent to about 0.5 weight of a powdered thixotropic agent based on amide wax.

Continuing with this example, the one-part dispensable 100 includes about 1 weight percent to about 9 weight percent (*e.g.,* about 4.5 weight percent, *etc.*) of the matrix based on a total weight of the one-part dispensable 100. The one-part dispensable 100 also includes about 85 weight percent to about 96 weight percent (*e.g.,* about 95 weight percent, *etc.*) of thermally-conductive filler within the matrix based on a total weight of the one-part dispensable 100.

Also in this example, the matrix comprises silicone resin, such as dimethyl silicone oil, *etc.* The thermally-conductive filler comprises one or more zinc oxide fillers (*e.g.,* about 12.5 weight percent of zinc oxide filler(s), *etc.*) and one or more alumina fillers (*e.g.,* about 82.5 weight percent of alumina filler(s), *etc.*)*.* The zinc oxide and alumina fillers may have different shapes (*e.g.,* irregular, spherical, *etc.)* and/or D₅₀ median particle sizes (*e.g.,* from about 0.8 micrometers to about 100 micrometers, *etc*.)*.* In this example, the one-part dispensable 100 is a single-part dispensable thermal interface material having a thermal conductivity of at least 6 Watts per meter per Kelvin (W/mK) and a stable flow rate within a range from 90 grams per minute to 125 grams per minute for at least 180 days.

FIGS. 2, 3, 4, and 5 include microscopic images showing a one-part dispensable (*e.g*., one-part dispensable 100 shown in FIG. 1*, etc.*) at different stages of activation of the temperature-activatable thixotropic agent (*e.g*., while the one-part dispensable is being heated up to a temperature of 80 °C to 100 °C for at least 15 minutes, *etc.*)*.* More specifically, FIG. 2 shows the one-part dispensable 200 at a first or initial activation stage before activation of the temperature-activatable thixotropic agent. FIG. 3 shows the one-part dispensable 300 at a second activation stage in which activation of the temperature-activatable thixotropic agent has begun. FIG. 4 shows the one-part dispensable 400 at a third activation stage in which the temperature-activatable thixotropic agent is activated. FIG. 5 shows the one-part dispensable 500 at a fifth activation stage in which the temperature-activatable thixotropic agent is fully activated.

The one-part dispensable shown in FIGS. 2, 3, 4, and 5 includes about 1 weight percent to about 9 weight percent (*e.g.,* about 4.5 weight percent, *etc.*) of a matrix based on a total weight of the one-part dispensable. The one-part dispensable also includes about 85 weight percent to about 96 weight percent (*e.g.,* about 95 weight percent, *etc.*) of thermally-conductive filler within the matrix based on a total weight of the one-part dispensable. The matrix comprised silicone resin, such as dimethyl silicone oil, *etc.* The thermally-conductive filler comprised one or more zinc oxide fillers (*e.g.,* about 12.5 weight percent of zinc oxide filler(s), *etc.*) and one or more alumina fillers (*e.g.,* about 82.5 weight percent of alumina filler(s), *etc.).* The zinc oxide and alumina fillers may have different shapes (*e.g.,* irregular, spherical, *etc.*) and/or D₅₀ median particle sizes (*e.g.,* from about 0.8 micrometers to about 100 micrometers, *etc.*)*.* In this example, the one-part dispensable is a single-part dispensable thermal interface material having a thermal conductivity of at least 6 Watts per meter per Kelvin (W/mK) (*e.g*., at least about 6.2 W/mK, *etc.*) and a stable flow rate within a range from 90 grams per minute to 125 grams per minute for at least 180 days.

FIG. 6 is a line graph of flow rate in grams per minute (g/min) versus time in days for first and second thermally-conductive single-part dispensables according to exemplary embodiments of the present disclosure. For comparison purposes, FIG. 6 also includes results for a conventional thermally conductive single-part dispensable that did not include a temperature-activatable thixotropic agent. In this example, the flow rate was determined by using a 75cc taper tip, 0.125 inch orifice, 90 psi. As shown in FIG. 6, the first and second thermally-conductive single-part dispensables had flow rates that were significantly higher than and that were more stable over time as compared to the flow rate over time of the conventional thermally-conductive single-part dispensable.

To obtain the flow rate over time shown in FIG. 6, each of the first and second thermally-conductive single-part dispensables included about 1 weight percent to about 9 weight percent (*e.g.,* about 4.5 weight percent, *etc.*) of a matrix based on a total weight of the thermally-conductive single-part dispensable. The one-part dispensable also included about 85 weight percent to about 96 weight percent (*e.g.,* about 95 weight percent, *etc.*) of thermally-conductive filler within the matrix based on the total weight of the thermally-conductive single-part dispensable. The matrix comprised silicone resin, such as dimethyl silicone oil, *etc.* The thermally-conductive filler comprised one or more zinc oxide fillers (*e.g.,* about 12.5 weight percent of zinc oxide filler(s), *etc.*) and one or more alumina fillers (*e.g.,* about 82.5 weight percent of alumina filler(s), *etc.).* The zinc oxide and alumina fillers may have different shapes (*e.g.,* irregular, spherical, *etc.*) and/or D₅₀ median particle sizes (*e.g.,* from about 0.8 micrometers to about 100 micrometers, *etc.*)*.* In this example, each of the first and second thermally-conductive single-part dispensables had a thermal conductivity of at least 6 Watts per meter per Kelvin (W/mK) (*e.g*., at least about 6.2 W/mK, *etc.*) and a stable flow rate within a range from 90 grams per minute to 125 grams per minute for at least 180 days.

In exemplary embodiments, a composite includes a temperature-activatable thixotropic agent and one or more fillers in a matrix. The one or more fillers comprise one or more of: thermally-conductive filler(s), electrically-conductive filler(s), electromagnetic wave absorbing filler(s), dielectric filler(s), and filler(s) that has two or more properties of being thermally conductive, electrically conductive, dielectric, and electromagnetic wave absorbing. In exemplary embodiments, the composite includes one or more fillers that comprise one or more of alumina, zinc oxide, aluminum, carbonyl iron, silicon carbide, boron nitride, silver, aluminum nitride, barium titanate, other typical thermally-conductive and/or EMI absorbing fillers, combinations thereof, *etc.* And the one or more fillers may have a D₅₀ median particle size in a range from about 0.1 micrometers to about 250 micrometers.

In exemplary embodiments, a composite includes a temperature-activatable thixotropic agent, thermally-conductive filler, and EMI absorbing filler in a matrix such that the composite comprises a multifunctional EMI absorber having a first functionality of EMI mitigation and a second functionality of thermal management, or vice versa. By way of example, the fillers may comprise one or more of functional nanoparticles, electrically-conductive fillers, thermally-conductive fillers, EMI or microwave absorbing fillers, magnetic fillers, coated fillers, combinations thereof, *etc.* The fillers may be added and mixed into a bulk material including the matrix material to thereby provide a mixture of the filler and base or matrix material. Example fillers include carbon black, boron nitride, nickel cobalt, carbonyl iron, iron silicide, iron particles, iron-chrome compounds, silver, an alloy containing 85% iron, 9.5% silicon and 5.5% aluminum, an alloy containing about 20% iron and 80% nickel, ferrites, magnetic alloys, magnetic powders, magnetic flakes, magnetic particles, nickel-based alloys and powders, chrome alloys, oxide, copper, zinc oxide, alumina, graphite, ceramics, silicon carbide, manganese zinc, fiberglass, carbon nanotubes (*e.g*., single-walled carbon nanotubes, multi-walled carbon nanotubes, and/or carbon nanostructures, *etc.*)*,* combinations thereof, *etc.* The fillers may comprise one or more of granules, spheroids, microspheres, ellipsoids, irregular spheroids, strands, flakes, powder, nanotubes, and/or a combination of any or all of these shapes. In addition, exemplary embodiments may also include different grades (*e.g.,* different sizes, different purities, different shapes, *etc.*) of the same (or different) fillers.

In exemplary embodiments, a composite includes a temperature-activatable thixotropic agent in a matrix, wherein the composite has a high thermal conductivity of at least 1 Watt per meter per Kelvin (W/mK) as determined by a Hot Disk Thermal Constants Analyzer. For example, the composite may have a thermal conductivity of 1 W/mK, 2 W/mK, 3 W/mK, 4 W/mK, 5 W/mK, 6 W/mK, more than 6 W/mK, *etc.* To determine thermal conductivity, a Hot Disk instrument may be used that measures thermal conductivity, thermal diffusivity, and specific heat capacity using the Transient Plane Source Method. By way of background, this technique is covered under the ISO 22007-2:2008; Part 2 Standard. The technique utilizes a plane sensor and a special mathematical model that describes the heat conductivity, combined with electronics that enables the method to be used to measure Thermal Transport Properties. It covers a thermal conductivity range of typically 0.01-500 W/m/K. The Transient Plane Source technique typically employs two samples halves sandwiching the sensor. This method can also be used in a single-sided configuration. The technique is versatile and fast, covering measurements of solids, pastes, thin films and liquids. The technique can test both isotropic and anisotropic material. The flat sensor includes a continuous double spiral of electrically conducting nickel metal, etched out of a thin foil. The nickel spiral is situated between two layers of thin polyimide film Kapton. During the measurement, a constant electrical effect is passed through the conducting spiral, increasing the sensor temperature. The heat generated dissipates into the sample on both sides of the sensor, at a rate depending on the thermal transport properties of the material. By recording temperature versus time response in the sensor, the thermal conductivity, thermal diffusivity, and specific heat capacity of the material can be calculated.

In exemplary embodiments, a high thermally-conductive single part dispensable includes a temperature-activatable thixotropic agent as disclosed herein. And the high thermally-conductive single part dispensable is configured to be suitable for automation and with vertical stability and reliability when used in a variety of application orientations. In addition to providing application flexibility and variable gap adaptation, the high thermally-conductive single part dispensable may be configured to exert reduced (*e.g.,* minimal, *etc.*) stress on a component while maintaining interface contact to increase (*e.g.,* maximize, *etc.).* Exemplary embodiments of the high thermally-conductive single part dispensables and other composites disclosed herein may be configured to be RoHS compliant, have thermal cycling stability, low outgassing per ASTM E595, have a flammability rating of V-O UL94, a minimum bond line thickness of about 0.150 millimeters, a thermal impedance within a range from about 5.5°C cm²/W to about 6.5°C cm²/W, a thermal conductivity of at least 6 W/mK, and a high stable flow rate (*e.g.,* at least about 100 grams per minute for at least 180 days, *etc.*)*.* In this example, the flow rate may be determined by using a 75cc taper tip, 0.125 inch orifice, 90 psi.

Disclosed are exemplary embodiments of composites useful for the management of heat and/or electromagnetic interference (EMI). In exemplary embodiments, a composite comprises a matrix, one or more fillers within the matrix, and a temperature-activatable thixotropic agent within the matrix. The temperature-activatable thixotropic agent is activatable upon heating of the composite to a predetermined minimum temperature for at least a predetermined minimum amount of time whereby activation of the temperature-activatable thixotropic agent increases flow rate and flow rate stability over time of the composite.

In exemplary embodiments, the temperature-activatable thixotropic agent is activatable upon heating of the composite to a temperature of at least 80 °C for at least 15 minutes.

In exemplary embodiments, the temperature-activatable thixotropic agent is configured to change structure or phase and/or to undergo a physical transformation or chemical transformation that induces or enhances thixotropic behavior of the temperature-activatable thixotropic agent thereby enhancing flow rate characteristics of the composite when the composite is heated to the predetermined minimum temperature for at least the predetermined minimum amount of time.

In exemplary embodiments, the composite is configured to have a flow rate of at least 95 grams per minute for at least 180 days.

In exemplary embodiments, the composite is configured to have a stable flow rate within a range from 90 grams per minute to 125 grams per minute for at least 180 days.

In exemplary embodiments, the temperature-activatable thixotropic agent is configured to increase the flow rate and the flow rate stability over time of the composite such that the composite has a flow rate that is higher and more stable over time as compared to another composite having substantially the same formulation but without the temperature-activatable thixotropic agent.

In exemplary embodiments, the composite comprises about 0.1 weight percent to about 0.5 weight percent of the temperature-activatable thixotropic agent based on a total weight of the composite. For example, the composite may include about 0.1 weight percent to about 0.5 weight of a powdered thixotropic agent based on amide wax. The composite may also comprise about 1 weight percent to about 9 weight percent (*e.g.,* about 4.5 weight percent, *etc.*) of the matrix based on a total weight of the composite, and about 85 weight percent to about 96 weight percent (*e.g.,* about 95 weight percent, *etc.*) of the thermally-conductive filler within the matrix based on a total weight of the composite. The matrix may comprise silicone resin (*e.g.,* dimethyl silicone oil, *etc.*)*.* The thermally-conductive filler may comprise one or more zinc oxide fillers (*e.g.,* about 12.5 weight percent of zinc oxide filler(s), *etc.*) and one or more alumina fillers (*e.g.,* about 82.5 weight percent of alumina filler(s), *etc.*)*,* which fillers may have different shapes (*e.g.,* irregular, spherical, *etc.*) and/or D₅₀ median particle sizes (*e.g.,* from about 0.8 micrometers to about 100 micrometers, *etc.*)*.* In this example, the composite may be a single-part dispensable thermal interface material having a thermal conductivity of at least 6 Watts per meter per Kelvin (W/mK) and a stable flow rate within a range from 90 grams per minute to 125 grams per minute for at least 180 days.

In exemplary embodiments, the composite is a one-part dispensable.

In exemplary embodiments, the composite is a one-part dispensable thermal interface material having a thermal conductivity of at least 6 Watts per meter per Kelvin (W/mK) and a stable flow rate within a range from 90 grams per minute to 125 grams per minute for at least 180 days.

In exemplary embodiments, the one or more fillers comprise one or more of zinc oxide, aluminum oxide, boron nitride, aluminum, silicon carbide, and/or aluminum nitride.

In exemplary embodiments, the composite comprises one or more of: thermally-conductive filler(s); electrically-conductive filler(s); electromagnetic wave absorbing filler(s); dielectric filler(s); and filler(s) that has two or more properties of being thermally conductive, electrically conductive, dielectric, and electromagnetic wave absorbing.

In exemplary embodiments, a device or system comprising a composite as disclosed herein.

Also disclosed are methods of enhancing flow rate characteristics of composites that are useful for management of heat and/or electromagnetic interference (EMI). In exemplary methods, a temperature-activatable thixotropic agent is used to increase flow rate and increase flow rate stability over time of the composite.

In exemplary methods, the temperature-activatable thixotropic agent is added to the matrix of the composite such that the composite includes the matrix, the one or more fillers within the matrix, and the temperature-activatable thixotropic agent within the matrix. Thereafter, the method includes heating the composite to activate the temperature-activatable thixotropic agent within the matrix of the composite.

In exemplary methods, the composite is heated to a predetermined minimum temperature for at least a predetermined minimum amount of time to activate the temperature-activatable thixotropic agent. For example, the composite may be to a temperature of at least 80 °C (*e.g.,* a temperature within a range from 80°C to 100°C, *etc.*) for at least 15 minutes to activate the temperature-activatable thixotropic agent.

In exemplary methods, the composite is heated to activate the temperature-activatable thixotropic agent to thereby cause the temperature-activatable thixotropic agent to change structure or phase and/or to undergo a physical transformation or chemical transformation that induces or enhances thixotropic behavior of the temperature-activatable thixotropic agent thereby enhancing flow rate characteristics of the composite.

In exemplary methods, the use of the temperature-activatable thixotropic agent increases flow rate and increases flow rate stability over time of the composite such that the composite is configured to have a flow rate of at least 95 grams per minute for at least 180 days.

In exemplary methods, the use of the temperature-activatable thixotropic agent increases flow rate and increases flow rate stability over time of the composite such that the composite is configured to have a stable flow rate within a range from 90 grams per minute to 125 grams per minute for at least 180 days.

In exemplary methods, the use of the temperature-activatable thixotropic agent to increases flow rate and increases flow rate stability over time of the composite such that the composite has a higher flow rate that is more stable over time as compared to another composite having substantially the same formulation but without the temperature-activatable thixotropic agent.

In exemplary methods, the composite comprises about 0.1 weight percent to about 0.5 weight percent of the temperature-activatable thixotropic agent based on a total weight of the composite. For example, the composite may include about 0.1 weight percent to about 0.5 weight of a powdered thixotropic agent based on amide wax. The composite may also comprise about 1 weight percent to about 9 weight percent (*e.g.,* about 4.5 weight percent, *etc.*) of the matrix based on a total weight of the composite, and about 85 weight percent to about 96 weight percent (*e.g.,* about 95 weight percent, *etc.*) of the thermally-conductive filler within the matrix based on a total weight of the composite. The matrix may comprise silicone resin (*e.g.,* dimethyl silicone oil, *etc.*)*.* The thermally-conductive filler may comprise one or more zinc oxide fillers (*e.g.,* about 12.5 weight percent of zinc oxide filler(s), *etc.*) and one or more alumina fillers (*e.g.,* about 82.5 weight percent of alumina filler(s), *etc.*)*,* which fillers may have different shapes (*e.g.,* irregular, spherical, *etc.*) and/or D₅₀ median particle sizes (*e.g.,* from about 0.8 micrometers to about 100 micrometers, *etc.*)*.* In this example, the composite may be a single-part dispensable thermal interface material having a thermal conductivity of at least 6 Watts per meter per Kelvin (W/mK) and a stable flow rate within a range from 90 grams per minute to 125 grams per minute for at least 180 days.

In exemplary methods, the composite is a one-part dispensable.

In exemplary methods, the composite is a one-part dispensable thermal interface material having a thermal conductivity of at least 6 Watts per meter per Kelvin (W/mK) and a stable flow rate within a range from 90 grams per minute to 125 grams per minute for at least 180 days. And the method may include dispensing the one-part dispensable thermal interface material between first and second components. The first and second components may comprise one or more of: a heat removal/dissipation structure such as a heat sink, a heat spreader, a heat pipe, a vapor chamber, a device exterior case, housing, or chassis; a heat source of an electronic device, such as an integrated circuit or other component of the electronic device; and/or a board level shield.

In an exemplary embodiments, an electronic device includes a heat source and a composite as disclosed herein that is usable as a one-part dispensable thermal interface material having a high thermal conductivity (*e.g.,* at least 6 W/mK, *etc.*) and a high stable flow rate (*e.g.,* 90 grams per minute to 125 grams per minute for at least 180 days, *etc.*)*.* The composite is dispensed (broadly, positioned) relative to the heat source for establishing at least a portion of a thermally-conductive heat path from the heat source through the composite. The composite may also be configured to be EMI absorbing and/or electrically conductive, such that the composite is also operable for mitigating and/or managing EMI within the electronic device.

In an exemplary embodiment, an electronic device includes a heat source, a heat removal/dissipation structure, and a composite as disclosed herein that is usable as a one-part dispensable thermal interface material having a high thermal conductivity (*e.g.,* at least 6 W/mK, *etc.*) and a high stable flow rate (*e.g.,* 90 grams per minute to 125 grams per minute for at least 180 days, *etc.*) The composite is dispensed (broadly, positioned) relative to the heat source and the heat removal/dissipation structure for establishing at least a portion of a thermally-conductive heat path between the heat source and the heat removal/dissipation structure. The composite may also be configured to be EMI absorbing and/or electrically conductive, such that the composite is also operable for mitigating and/or managing EMI within the electronic device.

In an exemplary embodiment, an electronic device includes a heat source, a board level shield, and a composite disclosed herein that is usable as a one-part dispensable thermal interface material having a high thermal conductivity (*e.g.,* at least 6 W/mK, *etc.*) and a high stable flow rate (*e.g.,* 90 grams per minute to 125 grams per minute for at least 180 days, *etc*.)*.* The composite is dispensed (broadly, positioned) relative to the heat source and the board level shield for establishing at least a portion of a thermally-conductive heat path between the heat source and the board level shield. The composite may also be configured to be EMI absorbing and/or electrically conductive, such that the composite is also operable for mitigating and/or managing EMI within the electronic device.

In an exemplary embodiment, an electronic device includes a heat source, a board level shield, a heat removal/dissipation structure, and first and second composites that are usable as usable as one-part dispensable thermal interface materials having a high thermal conductivity (*e.g*., at least 6 W/mK, *etc.*) and a high stable flow rate (*e.g.,* 90 grams per minute to 125 grams per minute for at least 180 days, *etc.*)*.* The first composite is dispensed (broadly, positioned) relative to the heat source and the board level shield for establishing at least a portion of a first thermally-conductive heat path between the heat source and the board level shield. The second composite is dispensed (broadly, positioned) relative to the board level shield and the heat removal/dissipation structure for establishing at least a portion of a second thermally-conductive heat path between the board level shield and the heat removal/dissipation structure. The first and/or second composites may also be configured to be EMI absorbing and/or electrically conductive, such that the first and/or second composites are also operable for mitigating and/or managing EMI within the electronic device.

In an exemplary embodiment, an electronic device includes an integrated circuit, a board level shield, a heat sink, and first and second composites that are usable as one-part dispensable thermal interface materials having a high thermal conductivity (*e.g.,* at least 6 W/mK, *etc.*) and a high stable flow rate (*e.g.,* 90 grams per minute to 125 grams per minute for at least 180 days, *etc.*) The first composite is dispensed (broadly, positioned) relative to the integrated circuit and the board level shield for establishing at least a portion of a first thermally-conductive heat path between the integrated circuit and the board level shield. The second composite is dispensed (broadly, positioned) relative to the board level shield and the heat sink for establishing at least a portion of a second thermally-conductive heat path between the board level shield and the heat sink. The first and/or second composites may also be configured to be EMI absorbing and/or electrically conductive, such that the first and/or second composites are also operable for mitigating and/or managing EMI within the electronic device.

Exemplary embodiments disclosed herein may be used in a wide range of industries (*e.g.,* automotive, consumer, industrial, datacom/telecom, aerospace/defense, *etc.*) and wide range of applications (*e.g*., automotive electronics, automotive advanced driver-assistance systems (ADAS), automotive powertrain/electronic control units (ECUs), automotive infotainment, routers, hard disk drives, solid state drives, wireless infrastructure, drones/satellites, gaming systems, smart home devices, notebooks/tablets/portable devices, *etc.*)*.* In addition, example embodiments disclosed herein may be used for a wide range of heat sources, electronic devices, and/or heat removal/dissipation structures or components (*e.g*., a heat spreader, a heat sink, a heat pipe, a vapor chamber, a device exterior case, housing, or chassis, *etc.*)*.* For example, a heat source may comprise one or more heat generating components or devices, such as a high-power integrated circuit (IC), optical transceiver, 5G infrastructure devices (*e.g.,* base stations, small cells, smart poles, *etc.*)*,* solid-state drive (SSD), memory in video cards, set top boxes, televisions, gaming systems, automotive electronics used for autonomous driving (ADAS) (*e.g.,* radars, multi domain controllers, cameras, *etc.*)*,* a CPU, die within underfill, semiconductor device, flip chip device, graphics processing unit (GPU), digital signal processor (DSP), multiprocessor system, integrated circuit (IC), multi-core processor, *etc.*)*.* Generally, a heat source may comprise any component or device that has a higher temperature than a thermal management and/or EMI mitigation material or otherwise provides or transfers heat to the thermal management and/or EMI mitigation material regardless of whether the heat is generated by the heat source or merely transferred through or via the heat source. Accordingly, aspects of the present disclosure should not be limited to use with any single type of heat source, electronic device, heat removal/dissipation structure, *etc.*

Example embodiments are provided so that this disclosure will be thorough and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i.e.,* the disclosure of a first value and a second value for a given parameter can be interpreted as disclosing that any value between the first and second values could also be employed for the given parameter). For example, if Parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. For example, when permissive phrases, such as "may comprise", "may include", and the like, are used herein, at least one embodiment comprises or includes the feature(s). As used herein, the singular forms "a", "an" and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on", "engaged to", "connected to" or "coupled to" another element or layer, it may be directly on, engaged, connected or coupled to the other element or layer, or intervening elements or layers may be present. In contrast, when an element is referred to as being "directly on," "directly engaged to", "directly connected to" or "directly coupled to" another element or layer, there may be no intervening elements or layers present. Other words used to describe the relationship between elements should be interpreted in a like fashion (*e.g*., "between" versus "directly between," "adjacent" versus "directly adjacent," *etc.*)*.* As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally", "about", and "substantially" may be used herein to mean within manufacturing tolerances. Or for example, the term "about" as used herein when modifying a quantity of an ingredient or reactant of the invention or employed refers to variation in the numerical quantity that can happen through typical measuring and handling procedures used, for example, when making concentrates or solutions in the real world through inadvertent error in these procedures; through differences in the manufacture, source, or purity of the ingredients employed to make the compositions or carry out the methods; and the like. The term "about" also encompasses amounts that differ due to different equilibrium conditions for a composition resulting from a particular initial mixture. Whether or not modified by the term "about", equivalents to the quantities are included.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath", "below", "lower", "above", "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A composite useful for the management of heat and/or electromagnetic interference (EMI), the composite comprising:
a matrix;
one or more fillers within the matrix; and
a temperature-activatable thixotropic agent within the matrix, the temperature-activatable thixotropic agent activatable upon heating of the composite to a predetermined minimum temperature for at least a predetermined minimum amount of time whereby activation of the temperature-activatable thixotropic agent increases flow rate and flow rate stability over time of the composite.

2. The composite of claim 1, wherein the temperature-activatable thixotropic agent is activatable upon heating of the composite to a temperature of at least 80 °C for at least 15 minutes.

3. The composite of any preceding claim, wherein the temperature-activatable thixotropic agent is configured to change structure or phase and/or to undergo a physical transformation or chemical transformation that induces or enhances thixotropic behavior of the temperature-activatable thixotropic agent thereby enhancing flow rate characteristics of the composite when the composite is heated to the predetermined minimum temperature for at least the predetermined minimum amount of time.

4. The composite of any preceding claim, wherein the composite is configured to have a stable flow rate of at least 90 grams per minute for at least 180 days.

5. The composite of any preceding claim, wherein the temperature-activatable thixotropic agent is configured to increase the flow rate and the flow rate stability over time of the composite such that the composite has a flow rate that is higher and more stable over time as compared to another composite having substantially the same formulation but without the temperature-activatable thixotropic agent.

6. The composite of any preceding claim, wherein the composite comprises about 0.1 weight percent to about 0.5 weight percent of the temperature-activatable thixotropic agent based on a total weight of the composite.

7. The composite of claim 6, wherein the composite comprises thermally-conductive filler within the matrix, and wherein the composite comprises:
about 1 weight percent to about 9 weight percent of the matrix based on a total weight of the composite; and
about 85 weight percent to about 96 weight percent of the thermally-conductive filler within the matrix based on a total weight of the composite.

8. The composite of claim 7, wherein:
the matrix comprises silicone resin;
the thermally-conductive filler comprises one or more zinc oxide fillers and one or more alumina fillers;
the temperature-activatable thixotropic agent comprises a powdered thixotropic agent based on amide wax; and
the composite is a single-part dispensable thermal interface material having a thermal conductivity of at least 6 Watts per meter per Kelvin (W/mK) and a stable flow rate of at least 90 grams per minute for at least 180 days.

9. The composite of any preceding claim, wherein the composite is a one-part dispensable having a thermal conductivity of at least 6 Watts per meter per Kelvin (W/mK) and a stable flow rate at least 90 grams per minute for at least 180 days.

10. A method of enhancing flow rate characteristics of a composite useful for management of heat and/or electromagnetic interference (EMI) that includes one or more fillers within a matrix, the method comprising using a temperature-activatable thixotropic agent to increase flow rate and increase flow rate stability over time of the composite.

11. The method of claim 10, wherein using the temperature-activatable thixotropic agent to increase flow rate and increase flow rate stability over time of the composite comprises:
adding the temperature-activatable thixotropic agent to the matrix of the composite such that the composite includes the matrix, the one or more fillers within the matrix, and the temperature-activatable thixotropic agent within the matrix; and
heating the composite to activate the temperature-activatable thixotropic agent within the matrix of the composite.

12. The method of claim 10 or 11, wherein the method includes:
heating the composite to a temperature of at least 80 °C for at least 15 minutes to activate the temperature-activatable thixotropic agent; and/or
heating the composite such that the temperature-activatable thixotropic agent changes structure or phase and/or undergoes a physical transformation or chemical transformation that induces or enhances thixotropic behavior of the temperature-activatable thixotropic agent thereby enhancing flow rate characteristics of the composite.

13. The method of any one of claims 10 to 12, wherein the method includes using the temperature-activatable thixotropic agent to increase flow rate and increase flow rate stability over time of the composite such that:
the composite has a stable flow rate of at least 90 grams per minute for at least 180 days; and/or
the composite has a higher flow rate that is more stable over time as compared to another composite having substantially the same formulation but without the temperature-activatable thixotropic agent.

14. The method of any one of claims 10 to 13, wherein the composite comprises:
about 0.1 weight percent to about 0.5 weight percent of the temperature-activatable thixotropic agent based on a total weight of the composite;
about 1 weight percent to about 9 weight percent of the matrix based on a total weight of the composite; and
about 85 weight percent to about 96 weight percent of thermally-conductive filler within the matrix based on a total weight of the composite.

15. The method of claim 14, wherein:
the matrix comprises silicone resin;
the thermally-conductive filler comprises one or more zinc oxide fillers and one or more alumina fillers;
the temperature-activatable thixotropic agent comprises a powdered thixotropic agent based on amide wax; and
the composite is a single-part dispensable thermal interface material having a thermal conductivity of at least 6 Watts per meter per Kelvin (W/mK) and a stable flow rate of at least 90 grams per minute for at least 180 days.
